Europäisches Patentamt

European Patent Office

Office européen des brevets

(11) Publication number : **0 469 848 A2**

(12) **EUROPEAN PATENT APPLICATION**

(21) Application number : 91306961.3

(22) Date of filing : 30.07.91

(51) Int. Cl.$^5$ : **H05K 3/34,** H05K 3/22, H05K 1/00

(30) Priority : 30.07.90 ZA 905965

(43) Date of publication of application :
05.02.92 Bulletin 92/06

(84) Designated Contracting States :
AT BE CH DE DK ES FR GB GR IT LI LU NL SE

(71) Applicant : **INDUSTRIAL DEVELOPMENT CORPORATION OF SOUTH AFRICA LIMITED**
**19 Fredman Drive**
**Sandton, Transvaal (ZA)**

(72) Inventor : **Carson, Mark Harley**
**3 Colombus Crescent Norscot Extension 1**
**Sandton Transvaal (ZA)**
Inventor : **Magee, David George**
**28 Celliers Street Sunnyside**
**Pretoria Transvaal (ZA)**

(74) Representative : **Crawford, Fiona Merle et al**
**Elkington and Fife Prospect house 8**
**Pembroke Road**
**Sevenoaks Kent TN13 1XR (GB)**

(54) **Attaching integrated circuits to circuit boards.**

(57)   A method of connecting an electronic component such as an integrated circuit (10) to a circuit board (24) comprises the steps of depositing solder (20) in a predetermined pattern on contact zones (12) of the electronic component ; raising the deposited solder relative to the contact zones ; bringing the electronic component and the circuit board into abutment so that the solder pattern on the one and complemental contact zones (26) on the other are aligned ; and reflowing the solder to join the component and the board. The deposited solder pattern can be formed by screen printing solder cream onto the contact zones. The solder can be reflowed to create solder bumps (22), or may simply be deposited to the required thickness. Alternatively, the solder pattern can be formed by wave soldering the contact zones, thereby depositing solder bumps (22) on the contact zones. The method can be used for connecting a number of electronic components simultaneously to a multiple circuit board, the multiple circuit board subsequently being cut into separate individual boards.

EP 0 469 848 A2

FIG. 1

## BACKGROUND OF THE INVENTION

This invention relates to a method of connecting electronic components such as integrated circuits to a circuit board, and to circuit board assemblies formed by the method.

In order to mass produce small, cheap electronic printed circuit boards (PCB's), it is desirable to mount the chip die of integrated circuits directly onto the circuit board, as opposed to soldering the pins of pre-packaged integrated circuits onto the board. Dispensing with the package reduces the cost and size of the resulting circuit board assembly. One technique which has been used to achieve this involves placing the integrated circuit chip on the PCB substrate and connecting fine wires between contact zones on the integrated circuit chip and the PCB by means of ultrasonic or other wire bonding techniques.

However, wire bonding techniques have limitations and are not suitable for mass production of cheap boards. This is because such techniques involve a step which must be done sequentially for each bond and each board. Wire bonds are also relatively fragile.

Another technique is known as the "flip chip" technique, and involves placing the integrated circuit chip and the PCB in face to face contact and connecting their respective contact zones by means of solder pillars. This has involved electrolytic plating or vacuum deposition of solder bumps on the integrated circuit chip or the PCB, which is a relatively expensive process.

It is an object of the invention to provide an alternative process.

## SUMMARY OF THE INVENTION

According to the invention a method of connecting an electronic component to a circuit board comprises the steps of :

depositing solder in a predetermined solder pattern on contact zones of one of the electronic component or the circuit board;

causing the deposited solder pattern to become raised relative to the contact zones;

bringing the electronic component and the circuit board into face-to-face abutment with one another so that the predetermined solder pattern on the one and complemental contact zones on the other are aligned; and

reflowing the solder to join the respective contact zones of the electronic component and the circuit board.

The deposited solder pattern may be formed by screen printing solder cream onto the contact zones.

The solder cream may be deposited in a layer at least 50 μ thick above the contact zones, so that the solder cream pattern projects sufficiently far for the remaining steps to be carried out.

Alternatively, the deposited solder cream is reflowed to form raised solder bumps on the contact zones prior to bringing the electronic component and the circuit board into face-to-face abutment.

In a variation of the method, the solder pattern is formed by wave soldering the contact zones, thereby depositing solder bumps on the contact zones.

The electronic component is typically an integrated circuit, which may be one of several formed on a larger wafer.

## BRIEF DESCRIPTION OF THE DRAWINGS

Figure 1 is a schematic sectional view of a contact zone on an integrated circuit chip which has been treated according to the method of the invention;

Figure 2 is a schematic sectional view illustrating the assembly of the integrated circuit chip onto a printed circuit board;

Figure 3 shows the completed assembly; and

Figure 4 shows an alternative process according to the invention.

## DESCRIPTION OF EMBODIMENTS

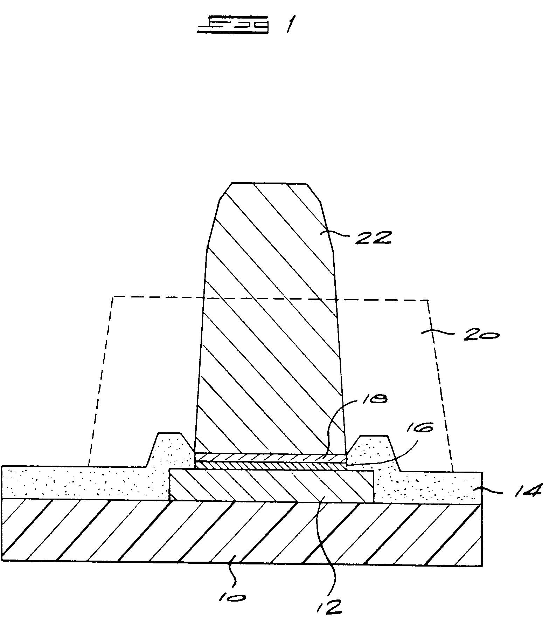

Figure 1 illustrates a contact zone of an integrated circuit chip. The chip is typically one of many on a silicon wafer. Each chip has a silicon substrate 10 on which an integrated circuit has been defined according to known techniques. Deposited on the substrate are aluminium contact zones 12. The surface of the chip is covered by an insulating passivation layer 14, with the exception of open regions directly above the aluminum contact zones 12.

In order to prepare the contact zones 12 for soldering, an "intermetallic" layer comprising layers 16 and 18 of, for example, zinc and nickel, is deposited by electroless plating on the exposed surface of the aluminium contact zone 12. The intermetallic layer is solderable. Next, a screen printing technique is used to apply a solder cream pattern to the surface of each integrated circuit chip, so that a solder cream deposit 20 is placed over each contact zone 12. The deposits 20 generally have a diameter which is larger than that of the contact zone 12 or the intermetallic layer 16, 18. The solder cream comprises about 10% by volume of flux, and about 90% by volume of solder balls. The wafer is now subjected to a solder reflowing process at about 250°C, causing the solder to adhere to the intermetallic layer and to form a raised solder bump 22, as shown in Figure 1. The diameter of the solder bump now corresponds approximately to that of the intermetallic layer, and the bump is raised correspondingly, since its volume remains substantially constant. The volume of the solder cream deposit over each contact zone is typically calculated to result in a solder bump 30 - 50 μ high after reflowing. Thus, each contact zone 12 of the integrated circuit chip now has a solder bump extending from it.

The printed circuit board (PCB) is prepared and patterned in a conventional manner. The printed circuit board typically comprises a glass fibre and resin substrate 24 with copper tracks 26 formed thereon. A solder mask 28 is now screen printed onto the PCB, and cured. This mask allows selective soldering, preventing bridging, and also acts as a solder dam, preventing "wicking" of molten solder along the copper tracks 26. The PCB is now cleaned further with a solvent, to ensure that the openings in the masking layer will be very clean. The PCB is then screen printed with solder cream in predetermined areas, providing solder cream deposits 30 above the copper conductors 26 in a pattern which is complemental to the solder pattern on the integrated circuit chips. Alternatively the PCB may simply be coated with a flux layer. The solder cream (or the flux layer) is now partially cured, so that it is tacky.

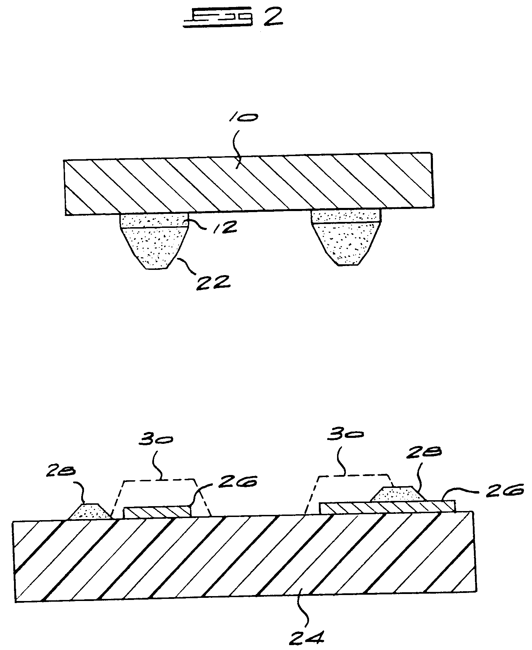

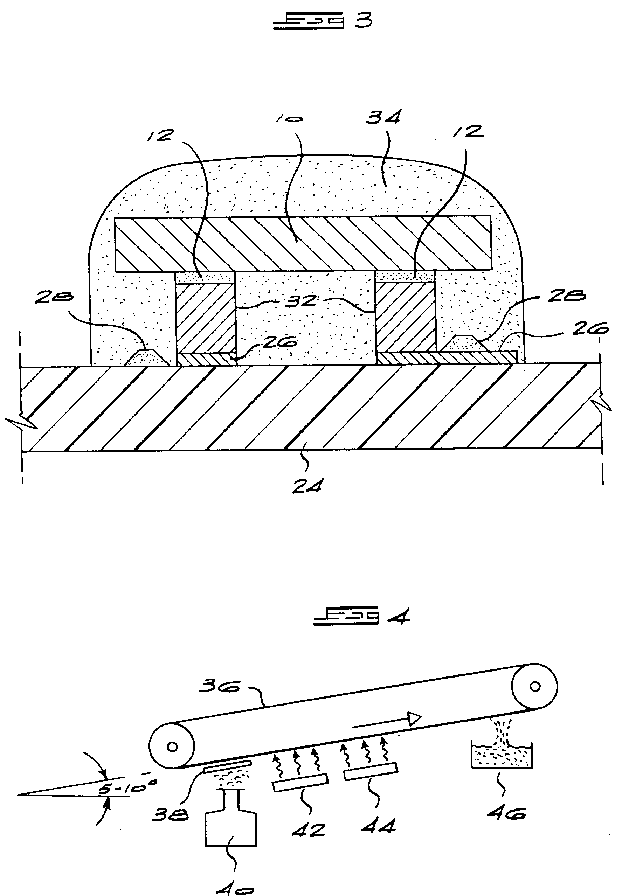

As illustrated in Figure 2, an integrated circuit chip (which has been cut from the multi-chip wafer) is oriented so that it is face-to-face with the printed circuit board 24, and the raised solder bumps 22 on the integrated circuit chip are aligned with the screen printed solder deposits 30 on the PCB. The chip may be handled by specially designed alignment equipment or by a pick and place machine. The chip is brought into abutment with the PCB, and the solder bumps are reflowed by passing the chip and the PCB through an infrared oven which heats them to about 250°C, causing the solder bumps to merge with the solder deposits 30 on the PCB, or to adhere directly to the copper tracks 26, as the case may be, thus forming solder pillars 32 (see Figure 3) between the integrated circuit chip and the PCB. The tacky surface of the solder cream or flux layer assists in retaining the integrated circuit chip in position on the PCB when the latter is moved to the solder reflowing machine.

The integrated circuit chip can now be covered by a "glob top" 34 of protective epoxy, to protect the chip from damage which may be incurred in further assembly steps. The resulting assembly is shown in Figure 3.

The described technique provides a relatively cheap and simple technique for mass production of printed circuit boards, while retaining the necessary accuracy in use.

An advantage of the technique is that a number of integrated circuit chips can be connected simultaneously to a large multiple circuit board, which can then be cut up into individual circuit board assemblies.

Variations of the above described method are possible. Instead of forming the raised solder bumps by reflowing a deposited solder cream pattern, it is possible instead to form raised solder bumps on the contact zones of the integrated circuit by a wave soldering process. In this version of the process, intermetallic layers 16 and 18 are deposited on the contact zone 12 of the silicon substrate 10 as described above. However, instead of depositing a solder cream pattern, the silicon wafer on which the integrated circuit is formed is wave soldered, resulting in a raised solder bump adhering to each contact zone 12, much as illustrated in Figure 1. The integrated circuit is then connected to the circuit board 24 as described above.

Figure 4 illustrates the wave soldering process schematically. A heat resistant conveyer belt 36, which is typically inclined at an angle of about 5° to 10° above the horizontal, carries a wafer 38 on which one or more integrated circuits are formed as described above. The conveyer belt travels in the direction of the arrow and first carries the wafer 38 past a foam fluxer 40 which coats the surface of the wafer with solder flux. The wafer then travels past first and second preheaters 42 and 44 which raise the temperature of the wafer towards the actual soldering temperature. Finally, the wafer 38 passes a "solder pot" 46 in which a solder wave or column contacts the surface of the wafer 38 as it passes the solder pot. This process deposits solder bumps on the contact zones 12. In the case of contact zones which are approximately 100 $\mu$ in diameter, solder bumps approximately 30 $\mu$ high are formed, using a type SN62 lead/tin solder at a temperature in the region of 250°C. A lead/tin/silver solder containing approximately 2% silver can also be used, at a somewhat lower temperature, so that a typical wave soldering temperature range is in the region of 220°C to 250°C.

In a second variation of the process, instead of reflowing or wave soldering the integrated circuit to form solder bumps, a raised solder cream pattern is printed on either the integrated circuit or the circuit board, with sufficient thickness so that the solder cream pattern itself projects sufficiently far from the contact zone over which it has been deposited for the remaining steps of the method to be carried out. Typically, the solder cream pattern deposited according to this variation of the method will be at least 50 $\mu$, and typically about 100 $\mu$ thick.

## Claims

1. A method of connecting an electronic component (10) to a circuit board (24) characterised in that it comprises the steps of:

depositing solder in a predetermined solder pattern (20) on contact zones (12) of one of the electronic component or the circuit board;

causing the deposited solder pattern to become raised relative to the contact zones (12);

bringing the electronic component and the circuit board into face-to-face abutment with one another so that the predetermined solder pattern (20) on the one and complemental contact zones (26) on the other are aligned; and

reflowing the solder to join the respective contact zones of the electronic component and the circuit board.

2. A method according to claim 1 characterised in that the deposited solder pattern (20) is formed by screen printing solder cream onto the contact zones (12).

3. A method according to claim 2 characterised in that the solder cream is deposited in a layer at least 50 μ thick above the contact zones (12).

4. A method according to claim 2 characterised in that the deposited solder cream is reflowed to form raised solder bumps (22) on the contact zones (12), prior to bringing the electronic component and the circuit board into face-to-face abutment.

5. A method according to claim 4 characterised in that the thickness of the deposited solder cream is calculated so that the solder bumps (22) formed by reflowing are at least 30 μ high.

6. A method according to claim 1 characterised in that the solder pattern is formed by wave soldering the contact zones, thereby depositing solder bumps (22) on the contact zones (12).

7. A method according to any one of claims 1 to 6 characterised in that it includes the step of depositing solder in a complemental solder pattern (30) on the complemental contact zones (26) of the other of the electronic component or the circuit board.

8. A method according to any one of claims 1 to 7 characterised in that the electronic component (10) is an integrated circuit.

9. A method according to any one of claims 1 to 8 characterised in that a solder mask (28) is deposited on at least one of the electronic component or the circuit board (10; 24) by screen printing prior to depositing solder thereon.

10. A method according to any one of claims 1 to 9 characterised in that a plurality of electronic components (10) formed on a silicon wafer have solder deposited on them simultaneously.

11. A method according to any one of claims 1 to 10 characterised in that a plurality of electronic components (10) are connected simultaneously to a multiple circuit board (24), the multiple circuit board subsequently being cut into separate individual boards.

12. A circuit board assembly characterised in that it is formed by the method of any one of claims 1 to 11.

_FIG 1_

$\underline{\underline{\mathbf{F I G}}}$ 2

FIG 3

FIG 4